# EUROPEAN PATENT APPLICATION

(11) **EP 4 588 904 A1**
(43) Date of publication of application: **23.07.2025**
(21) Application number: 23865544.3
(22) Date of filing: 13.09.2023
(51) Int. Cl.: C04B 35/587, H01L 23/15

(54) **WAFER MADE OF SINTERED SILICON NITRIDE AND METHOD FOR PRODUCING SINGLE CRYSTAL USING SAME**

(30) Priority: 13.09.2022 JP 2022145168
(71) Applicant: Kabushiki Kaisha Toshiba, Tokyo 105-0023 (JP); Toshiba Materials Co., Ltd., Isogo-Ku Yokohama-Shi Kanagawa 235-0032 (JP)
(72) Inventor: KANAHARA, Keita, Yokohama-shi, Kanagawa 235-0032 (JP); SASAKI, Akito, Yokohama-shi, Kanagawa 235-0032 (JP); IWAI, Kentaro, Yokohama-shi, Kanagawa 235-0032 (JP)
(74) Representative: Henkel & Partner mbB
(86) International application number: PCT/JP2023/033288
(87) International publication number: WO 2024/058195

(57) **Abstract**

A sintered silicon nitride wafer according to an embodiment has a flat plate-shape. In the sintered silicon nitride wafer, at least one surface of the wafer has a mean value, of mean lengths RSm of a plurality of roughness profile elements having a length of a plurality of line segments passing through the center of the surface being taken as a standard length, within the range of 100 µm or larger and 350 µm or smaller.

## Description

### TECHNICAL FIELD

The embodiments described below generally relate to a sintered silicon nitride wafer and a method for producing a single crystal body using the same.

### BACKGROUND ART

Silicon nitride substrates are used for circuit boards by taking advantage of their high strength and high thermal conductivity. For example, Japanese Patent No. 6293772 (Patent Document 1) discloses a silicon nitride substrate having a thermal conductivity of 50 W/m.K or higher and a three-point bending strength of 600 MPa or higher. The silicon nitride substrate of Patent Document 1 is excellent in insulating performance such as dielectric strength. In order to take advantage of insulation of the silicon nitride substrate, applications other than circuit boards are also being studied.

For example, in Japanese Patent No. 6992364 (Patent Document 2) and Japanese Patent Laid-Open No. 2006-282500 (Patent Document 3), a silicon nitride substrate is used as a substrate for disposing a single crystal. Such a base material for disposing a single crystal is called a wafer.

### PRIOR ART DOCUMENTS

### PATENT DOCUMENT

Patent Document 1: Japanese Patent No. 6293772
Patent Document 2: Japanese Patent No. 6992364
Patent Document 3: Japanese Patent Laid-Open No. 2006-282500

### SUMMARY OF THE INVENTION

### PROBLEMS TO BE SOLVED BY THE INVENTION

The sintered silicon nitride wafer in Patent Document 2 is improved in insulation by controlling the density at the center part and the edge part. However, adhesion with a single crystal has not been necessarily satisfactory.

A sintered silicon nitride wafer according to embodiments is intended to address such a problem, and the sintered silicon nitride wafer good in adhesion with a single crystal is provided.

### MEANS FOR SOLVING THE PROBLEMS

A sintered silicon nitride wafer according to an embodiment has a flat plate-shape. In the sintered silicon nitride wafer, at least one surface of the wafer has a mean value, of mean lengths RSm of a plurality of roughness profile elements having a length of a plurality of line segments passing through the center of the surface being taken as a standard length, within the range of 100 µm or larger and 350 µm or smaller.

### BRIEF DESCRIPTION OF THE DRAWINGS

FIG. 1 is a perspective view showing an example of a sintered silicon nitride wafer according to an embodiment.
FIG. 2 is a top view showing an example of a sintered silicon nitride wafer according to an embodiment.
FIG. 3 is a side view showing an example of a method for producing a single crystal body (having no thin film) according to an embodiment.
FIG. 4 is a side view showing an example of a method for producing a single crystal body (having a thin film) according to an embodiment.

### DESCRIPTION OF EMBODIMENTS

A sintered silicon nitride wafer according to an embodiment has a flat plate-shape. In the sintered silicon nitride wafer, at least one surface of the wafer has a mean value, of mean lengths RSm of a plurality of roughness profile elements having a length of a plurality of line segments passing through the center of the surface being taken as a standard length, within the range of 100 µm or larger and 350 µm or smaller.

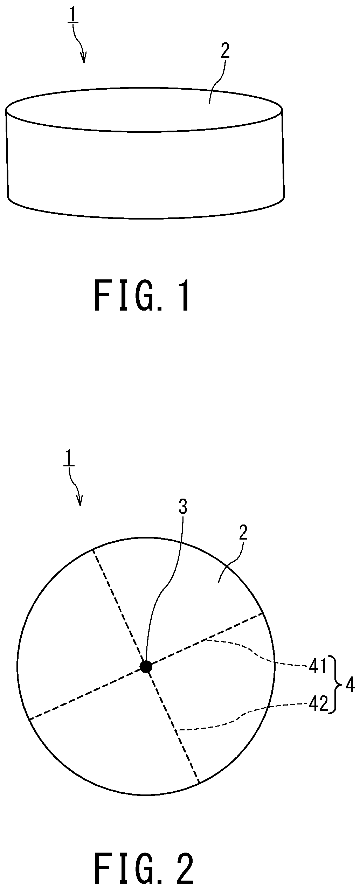

In FIG. 1 and FIG. 2 each, an example of a sintered silicon nitride wafer according to embodiments is shown. In the figures, reference numeral 1 denotes a sintered silicon nitride wafer; reference numeral 2 denotes one surface of the sintered silicon nitride wafer 1; reference numeral 3 denotes the center of the surface 2; reference numeral 4 denotes a plurality of line segments passing through the center 3 (for example, in the case of a disc shape, a "line segment" means a diameter, and in the case of a polygonal shape, a "line segment" means a diagonal); and reference numerals 41 and 42 denote two of the line segments 4.

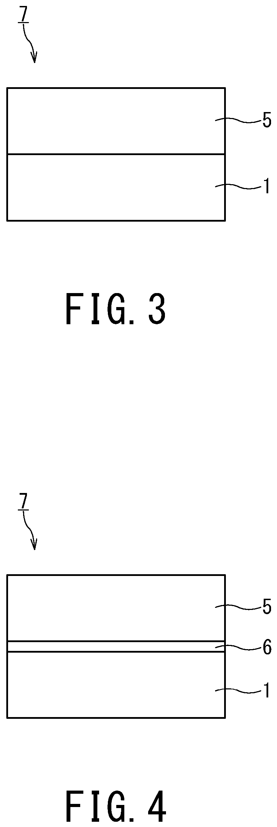

The sintered silicon nitride wafer 1 is made of a flat plate-shaped sintered silicon nitride. FIG. 1 shows a disc shape as an example. The wafer according to the embodiments is not limited to a disc shape, and various shapes such as polygonal shapes such as square ones, and ellipse shapes are applicable. The sintered silicon nitride wafer 1 according to the embodiments is for disposing a single crystal 5 (shown in FIG. 3 and FIG. 4) in order to produce a single crystal body 7 (shown in FIG. 3 and FIG. 4). That is, the surface 2 is used as a place to dispose the single crystal 5. Hence, the wafer is differentiated from those used for silicon nitride circuit boards in which a metal plate is joined to a silicon nitride substrate.

At least one surface of the sintered silicon nitride wafer 1 has such a feature that the mean value of mean lengths RSm of a plurality of roughness profile elements having a length of a plurality of line segments passing through the center of the surface being taken as a standard length, is within the range of 100 µm or larger and 350 µm or smaller. Hereinafter, the sintered silicon nitride wafer 1 may also be referred to simply as the wafer 1.

First, the center 3 and the plurality of line segments 4 will be described. The center 3 is the center of gravity of the surface 2. When the surface 2 is circular, the center 3 is the center point. Therefore, in the case where the surface 2 is circular, the plurality of line segments are each a diameter. Then, in the case where the surface 2 is not circular, the center of gravity is the center 3. The plurality of line segments 4 pass through the center 3 and are straight lines from one edge part of the surface 2 to the opposite edge part.

The sintered silicon nitride wafer 1 according to the embodiments has such a feature that the mean value of mean lengths RSm of a plurality of roughness profile elements having a length of a plurality of line segments passing through the center of the surface being taken as a standard length, is within the range of 100 µm or larger and 350 µm or smaller.

The mean length RSm of roughness profile elements is a mean value of lengths Xs of profile elements on a standard length. It is a parameter for evaluating the unevenness of the surface 2 in a depth direction of the sintered silicon nitride wafer 1 as a magnitude in a line segment direction passing through the center 3 of the surface 2. The mean length RSm of roughness profile elements is defined in JIS-B-0601 (2013). As defined in JIS-B-0601 (2013), the mean length RSm of the roughness profile elements requires the discrimination of the minimum height and the minimum length for determining profile peaks and profile valleys. The standard value of the discriminatable minimum height is set to be 10% of the maximum height roughness Rz. The standard value of the discriminatable minimum length is set to be 1% of the standard length. The mean value of the lengths Xs of the profile elements is obtained after profile peaks and profile valleys are determined so as to satisfy both of these two conditions. Here, JIS-B-0601 corresponds to ISO4287.

The measurements of RSm, Rt and Rv are carried out by the methods according to JIS-B-0601 (2013). The measurement conditions are: the standard length: 10 mm or larger (for example, in the case where the wafer 1 is of a disk shape, diameter), the measurement speed: 0.6 mm/s, the shape removal: least squares straight line, the λs filter: present, the λs cutoff ratio: 300, the cutoff type: Gaussian, and the cutoff wavelength (λc): 0.8 mm. When one-time measurement cannot secure 10 mm or larger of the standard length, the measurement is allowed to be divided into a plurality of the measurements. Under this condition, the measurement on a straight line passing through the center is carried out. The measurement uses a contact-type roughness measuring device. If an optical roughness measuring device is used, there is such a possibility that the polished surface cannot be measured due to reflection. The optical roughness measuring device includes a laser type.

RSm, Rt and Rv are each measured on a plurality of line segments 4. The plurality of line segments 4 are arbitrary ones as long as passing through the center 3. For example, the number of the plurality of line segments 4 passing through the center 3 is set to be five, and five mean values of RSm are measured. The wafer 1 according to the embodiments has such a feature that the mean value of RSm on any of the line segments 4 is within the range of 100 µm or larger and 350 µm or smaller.

In the sintered silicon nitride wafer 1 according to the embodiments, the mean value of RSm on a plurality of line segments 4 is within the range of 100 µm or larger to 350 µm or smaller. As described above, RSm is the length of one cycle of profile peak and profile valley. As will be described later, the sintered silicon nitride wafer 1 is used in a step of disposing the single crystal 5. When the mean value of RSm is in a predetermined range, both the joining strength and the adhesion can simultaneously be attained.

A small RSm indicates that one cycle of profile peak and profile valley is short. Then, a large RSm indicates that one cycle of profile peak and profile valley is long. A small RSm can attain an anchor effect. On the other hand, a small RSm makes it easier for gaps to be formed between the wafer 1 and the single crystal 5. Hence, it is preferable that the mean value of RSm on a plurality of line segments 4 is within the range of 100 µm or larger to 350 µm or smaller, and further, within the range of 150 µm or larger to 300 µm or smaller.

The state that the mean value of RSm of a plurality of line segments 4 passing through the center 3 is in a predetermined range indicates that the dispersion in RSm in diameter directions is small. Thereby, the dispersion in adhesion when the single crystal 5 is disposed can be suppressed. If RSm is smaller than 100 µm, an anchor effect can be attained, but there is such a possibility that gaps are formed between the wafer 1 and the single crystal 5. Then, if RSm is larger than 350 µm, gaps between the wafer 1 and the single crystal 5 can be suppressed, but there is such a possibility that the joining strength is lowered.

The other surface of the wafer 1, that is, the back surface (the surface on which the single crystal 5 is not to be disposed), may be made, similarly to the front surface, to be a polished surface, or may not be polished. By making the back surface of the wafer 1 to be a polished surface similar to the front surface (mean value of RSm is within the range of 100 µm or larger to 350 µm or smaller), either of the front and back surfaces can be used as a surface for disposing the single crystal 5. Thereby, a step of disposing the single crystal 5 can be dealt with without being particular about the front and back of the wafer 1. In other words, if the front and back of the wafer 1 can be distinguished, it is preferable not to polish the back surface. Not polishing the back surface can prevent an increase in cost.

As described later, it is preferable that the wafer 1 for disposing the single crystal 5 is circular. By controlling RSm of a plurality of line segments 4, the dispersions in the joining strength and the adhesion in a diameter direction in the circular shape can be suppressed.

Then, it is preferable that RSm is within the range of 10 µm or larger and 800 µm or smaller. As described above, RSm is measured on a standard length of 10 mm or larger. Due to that each RSm measured under this condition is within the range of 10 µm or larger and 800 µm or smaller, the dispersion in RSm can be suppressed. Thereby, the adhesion can further be improved.

When the joining strength between the sintered silicon nitride wafer 1 and the single crystal 5 is taken into consideration, if the joining strength at the outer periphery portions is good, problems such as peeling and positional shift can be suppressed.

It is preferable that the mean value of maximum profile valley depths Rv of a plurality of a roughness profile having a plurality of line segments 4 passing through the center 3 being taken as the standard lengths, is within the range of 0.04 µm or larger and 0.4 µm or smaller. For example, the number of a plurality of line segments 4 passing through the center 3 is set to be five, and the mean value of Rv of the five line segments 4 is measured. The mean value of Rv is a mean value when Rv are measured on standard lengths of 10 mm or larger on the plurality of line segments 4.

Then, it is preferable that the maximum profile valley depths Rv of a plurality of the roughness profile having a plurality of line segments 4 passing through the center 3 being taken as the standard lengths, are each within the range of 0.02 µm or larger and 2 µm or smaller. These maximum profile valley depths are respective values of maximum profile valley depths Rv obtained on standard lengths of 10 mm or larger on the plurality of line segments 4.

The maximum profile valley depth Rv of the roughness profile is a depth of the deepest profile valley in the roughness profile. The deeper the profile valley, the larger the Rv. Due to that the mean value of Rv of a plurality of line segments 4 passing through the center 3 is within the range of 0.04 µm or larger and 0.4 µm or smaller, the joining strength and the adhesion can further be improved. Then, due to that the each Rv value obtained on a standard length of 10 mm or larger is within the range of 0.02 µm or larger and 2 µm or smaller, the improvement can further be made.

It is preferable that the mean value of maximum heights Rt of a plurality of the roughness profile having a plurality of line segments 4 passing through the center 3 being taken as the standard lengths, is within the range of 0.4 µm or larger and 2 µm or smaller. For example, the number of the plurality of line segments 4 passing through the center 3 is set to be five, and the mean value of five Rt is measured. The mean value of Rt is a mean value when Rt are measured on standard lengths of 10 mm or larger (for example, in the case of a disc-shaped wafer 1, diameter) on the plurality of line segments 4.

Then, it is preferable that the maximum heights Rt of a plurality of the roughness profile having a plurality of line segments 4 passing through the center 3 being taken as the standard lengths, are each within the range of 0.1 µm or larger and 4 µm or smaller. These maximum heights Rt are respective values of maximum heights Rt obtained on the standard lengths of 10 mm or larger on the plurality of line segments 4.

The maximum height Rt of the roughness profile is a height of the highest profile peak in the roughness profile.

Due to that the mean value of Rt having a plurality of line segments 4 passing through the center 3 being taken as the standard lengths, is within the range of 0.4 µm or larger and 2 µm or smaller, the joining strength and the adhesion can further be improved. Then, due to that the each Rv value obtained on a standard length of 10 mm or larger is within the range of 0.1 µm or larger and 4 µm or smaller, the improvement can further be made.

It is effective that after RSm is controlled as described above, Rv and Rt are controlled. Further, Rv and Rt can be applied each singly or in combination.

RSm undergoes control of one cycle of profile peak and profile valley; Rv, control of the profile valley depth; and Rt, control of the profile peak height. Thereby, simultaneous satisfaction of both the joining strength and the adhesion is attained.

It is preferable that the sintered silicon nitride has a thermal conductivity of 50 W/m·K or higher and a three-point bending strength of 600 MPa or higher. High thermal conductivity improves heat dissipation. The high strength reduces the possibility of damage by transportation when the single crystal 5 is disposed. That is, the throughput becomes good. Then, the silicon nitride substrate is mainly composed of silicon nitride crystal grains with an aspect ratio of 1.5 or higher. The strength can be made high by entanglement of the slender silicon nitride crystal grains. Control of RSm is made easy by random orientation of the slender silicon nitride crystal grains.

The sintered silicon nitride is preferably one containing grain boundary phases within the range of 1% by mass or more and 20% by mass or less. The inclusion of grain boundary phases can make the density of the sintered silicon nitride to be within the range of 95% or higher and 100% or lower of the theoretical density. It is effective also for control of the surface roughness.

The linear expansion coefficient of the sintered silicon nitride is preferably within the range of 2.4 × 10⁻⁶/K or higher and 3.2 × 10⁻⁶/K or lower. The linear expansion coefficient is a value from room temperature to 300°C in the average linear expansion coefficient test of JIS-C-2141. The linear expansion coefficient indicates a rate per temperature unit of expansion of the length or volume of an object by a rise in temperature. The linear expansion coefficient is called the thermal expansion coefficient in some cases. Substrates for disposing the single crystal 5 include sapphire substrates and aluminum nitride substrates. The linear expansion coefficient of the sapphire substrates is about 5.5 × 10⁻⁶/K. The linear expansion coefficient of the aluminum nitride substrate is about 4.5 × 10⁻⁶/K. The linear expansion of the sintered silicon nitride is low. Hence, deformation by heat is suppressed. By suppressing deformation by heat, the above-mentioned merit of the surface roughness can be made the best use of. For example, the temperature in the epitaxial growth of gallium nitride (GaN) rises to about 1,000°C. Then, the temperature in the epitaxial growth of silicon carbide (SiC) rises to about 1,500. The linear expansion coefficient of the sintered silicon nitride can be controlled by the content of the grain boundary phases. Hence, the content of the grain boundary phases is preferably within the range of 1% by mass or higher and 20% by mass or lower, and more preferably within the range of 3% by mass or higher and 15% by mass or lower.

The surface 2 of the sintered silicon nitride wafer 1 is preferably disc-shaped. The silicon nitride sintered wafer 1 which has a shape of the surface being circular or polygonal when viewed from above can be used. Then, the circular shape include perfect circles and ellipses. The polygonal shape include triangle, rectangle, pentagonal and hexagonal ones.

The single crystal 5 is disc-shaped in many cases. For example, the diameter and thickness of silicon single crystals are determined by the SEMI (Semiconductor Equipment and Materials International) standard. Silicon single crystals are called silicon wafers in some cases. By making equal the size of the single crystal 5 and the diameter (a line segment passing through the center 3) of the sintered silicon nitride wafer 1, it becomes easy to use them in the production step of semiconductor devices.

The diameter (a line segment passing through the center 3) of the surface 2 of the sintered silicon nitride wafer 1 is preferably 40 mm or larger. Further, it is preferable that the diameter (a line segment passing through the center 3) of the surface 2 of the sintered silicon nitride wafer 1 is made equal to the diameter of the single crystal 5. The thickness of the sintered silicon nitride wafer 1 is preferably within the range of 0.2 mm or larger and 3 mm or smaller.

The sintered silicon nitride wafer 1 as described above can be used in a step of disposing the single crystal 5. In FIG. 3 and FIG. 4, shown is an example of the structure of a single crystal body 7 in which a single crystal 5 is disposed on a sintered silicon nitride wafer 1. In the Figs., reference numeral 1 denotes the sintered silicon nitride wafer; reference numeral 5 denotes the single crystal; reference numeral 6 denotes a thin film; and reference numeral 7 denotes the single crystal body.

The single crystal 5 includes silicon and compound semiconductors. The compound semiconductors include GaN-based, InN-based, AlN-based and SiC-based ones. The GaN-based ones include GaN, GaInN, GaAlN and GaInAlN.

The step of disposing the single crystal 5 on the sintered silicon nitride wafer 1 includes a step of stacking the single crystal 5 on the sintered silicon nitride wafer 1, and a step of growing the single crystal 5.

The step of stacking the single crystal 5 on the sintered silicon nitride wafer 1, as shown in FIG. 3, includes a method of directly disposing the single crystal 5 on the sintered silicon nitride wafer 1. Alternatively, a thin film 6 may be formed on the sintered silicon nitride wafer 1, and thereafter, the single crystal 5 may be disposed on the thin film 6 formed. Then, the step of growing the single crystal 5 includes gas phase methods and liquid phase methods. Before the crystal growth step is carried out, the thin film 6 may be formed on the sintered silicon nitride wafer 1. The thin film 6 to be formed on the sintered silicon nitride wafer 1 is preferably of the same composition as the single crystal 5. The thin film 6 of the same composition as the single crystal 5 can play the role of a seed crystal in the crystal growth step. The wafer 1 according to the embodiments functions effectively even when the single crystal 5 is disposed through the thin film 6.

After the single crystal 5 is disposed on the sintered silicon nitride wafer 1, a step of producing a semiconductor device can be carried out. In the step of producing a semiconductor device, the sintered silicon nitride wafer 1 may be used as a base material. Alternatively, the sintered silicon nitride wafer 1 may be removed and then, only the single crystal 5 may be used in the step of producing a semiconductor device. A sintered silicon nitride wafer 1 having the single crystal 5 disposed thereon, and a sintered silicon nitride wafer 1 having the single crystal 5 disposed thereon through the thin film 6 are called single crystal bodies.

By controlling RSm of the surface 2 of the sintered silicon nitride wafer 1 on which the single crystal 5 is to be disposed, both the joining strength and the adhesion can simultaneously be attained. The widening of gaps between the sintered silicon nitride wafer 1 and the single crystal 5 due to stress caused by the difference in thermal expansion between the sintered silicon nitride wafer 1 and the single crystal 5 can be suppressed. Further, by controlling Rv and Rt, the suppression can be promoted.

Then, a method for producing the sintered silicon nitride wafer 1 according to the embodiments will be described. The production method is not limited as long as the sintered silicon nitride wafer 1 according to the embodiments has the above-mentioned constitution, but a method giving high yield include the following.

First, a silicon nitride powder and a sintering aid powder are prepared. The amount of the sintering aid to be added is made to be within the range of 1% by mass or larger and 20% by mass or smaller. The sintering aid includes one or two or more oxides of elements selected from rare earth elements, magnesium, hafnium and titanium. In particular, it is preferable to add an oxide of a rare earth element as an essential component and one or two or more oxides selected from oxides of magnesium, hafnium and titanium.

A mixed raw material powder of the silicon nitride powder and the sintering aid powder is prepared. The mixed raw material powder, a binder and the like are mixed to prepare a raw material powder slurry.

Then, the raw material powder slurry is subjected to a molding step. The molding step can use a well-known method such as a doctor blade method or a mold molding method.

It is preferable to process an obtained molded article into an objective shape. For example, when a disc-shaped sintered silicon nitride wafer is to be obtained, it is preferable that the molded article has been made to be disc-shaped. Further, for the thickness regulation, molded articles are allowed to be stacked.

Then, a step of degreasing the molded article is carried out. The degreasing step is carried out preferably within the range of 300°C or higher and 700°C or lower. Then, a step of sintering the resulting degreased body is carried out. The sintering step is carried out preferably within the range of 1,600°C or higher and 1,900°C or lower.

Then, a step of polishing the surface of the obtained sintered silicon nitride is carried out. The polishing is carried out so that RSm, Rv and Rt of a plurality of line segments 4 passing through the center 3 of the surface 2 fall within predetermined ranges. For this purpose, it is effective to carry out the polishing process while the flat plate-shaped sintered silicon nitride is rotated.

### (Examples)

### (Examples 1 to 5, Comparative Examples 1 and 2)

Sintered silicon nitrides indicated in Table 1 were prepared. The sintered silicon nitrides were ones having, as sintering aids, an oxide of a rare earth element, and one or two or more selected from oxides of magnesium, hafnium and titanium added thereto. Any thereof was made to be a disc-shaped sintered silicon nitride.

**[Table 1]**

| | Content of Grain Boundary Phase [% by mass] | Thermal Conductivity [W/m K] | Three-point Bending Strength [MPa] | Linear Expansion Coefficient [×10⁻⁶/K] |
|---|---|---|---|---|
| Sintered Silicon Nitride 1 | 5 | 85 | 650 | 2.5 |
| Sintered Silicon Nitride 2 | 8 | 90 | 800 | 2.8 |
| Sintered Silicon Nitride 3 | 10 | 95 | 720 | 3.0 |

Then, by polishing the surface of the disc-shaped sintered silicon nitrides to control the surface roughness, sintered silicon nitride wafers 1 according to Examples and sintered silicon nitride wafers according to Comparative Examples were fabricated. The surface roughness, and the diameter and the thickness of the discs were as shown in Tables 2 and 3. Here, a diameter of 125 mm corresponded to 5 inches, and a diameter of 150 mm corresponded to 6 inches.

The surface roughness was expressed by RSm, Rv and Rt, and the measurement conditions were as described above. The mean values were each a mean value of a plurality of values determined on a plurality of segments 4 (in the case of a circular wafer, diameter) passing through the center of one surface of the disc. For each of RSm, Rv and Rt, the mean value, the minimum value and the maximum value in the case where the diameter was taken as the standard length are shown.

**[Table 2]**

| | Type of Sintered Silicon Nitride | Diameter [mm] | Thickness [mm] |
|---|---|---|---|
| Example 1 | Sintered Silicon Nitride 1 | 125 | 0.6 |
| Example 2 | Sintered Silicon Nitride 1 | 150 | 1.0 |
| Example 3 | Sintered Silicon Nitride 2 | 125 | 0.8 |
| Example 4 | Sintered Silicon Nitride 2 | 150 | 0.8 |
| Example 5 | Sintered Silicon Nitride 3 | 150 | 1.0 |
| Comparative Example 1 | Sintered Silicon Nitride 3 | 150 | 0.6 |
| Comparative Example 2 | Sintered Silicon Nitride 3 | 150 | 0.6 |

**[Table 3]**

| | RSm [µm] | | | Rv [µm] | | |
|---|---|---|---|---|---|---|
| | AVE. | Min. | Max. | AVE. | Min. | Max. |
| Example 1 | 155 | 38 | 576 | 0.07 | 0.02 | 1.3 |
| Example 2 | 197 | 89 | 688 | 0.21 | 0.09 | 1.5 |
| Example 3 | 237 | 113 | 739 | 0.32 | 0.10 | 1.8 |
| Example 4 | 269 | 45 | 488 | 0.08 | 0.03 | 1.2 |
| Example 5 | 297 | 142 | 642 | 0.09 | 0.03 | 1.6 |
| Comparative Example 1 | 521 | 185 | 1052 | 0.72 | 0.10 | 4.2 |
| Comparative Example 2 | 54 | 7 | 231 | 0.01 | <0.01 | 0.26 |

| | Rt [µm] | | | | | |
|---|---|---|---|---|---|---|
| | AVE. | | Min. | | Max. | |
| Example 1 | 0.4 | | 0.1 | | 1.8 | |
| Example 2 | 0.7 | | 0.3 | | 2.2 | |
| Example 3 | 1.0 | | 0.4 | | 2.8 | |
| Example 4 | 1.2 | | 0.5 | | 3.0 | |
| Example 5 | 0.8 | | 0.2 | | 2.1 | |
| Comparative Example 1 | 2.6 | | 1.1 | | 8.1 | |
| Comparative Example 2 | 0.1 | | <0.01 | | 0.34 | |

In the sintered silicon nitride wafers 1 according to Examples, RSm of a plurality of line segments 4 (in the case of a circular wafer, diameter) passing through the center 3 was made to be within the range of 100 µm or larger and 350 µm or smaller. Rv and Rt were also made to be in predetermined ranges.

By contrast, in the sintered silicon nitride wafer according to Comparative Example 1, the mean value of RSm was large. The mean values of Rv and Rt were also large. That is, in Comparative Example 1, one cycle of profile peak and profile valley was large and profile peaks and profile valleys were large.

Then, in the sintered silicon nitride wafer according to Comparative Example 2, the mean value of RSm was small. The mean values of Rv and Rt were also small. That is, in Comparative Example 2, one cycle of profile peak and profile valley was small and profile peaks and profile valleys were small.

Then, any of surface roughnesses Ra of the sintered silicon nitride wafers 1 according to Examples and the sintered silicon nitride wafers according to Comparative Examples was 0.1 µm or smaller. It was found that even with Ra being equal, different RSm gave different effects.

Then, a step of disposing a single crystal on the sintered silicon nitride wafers 1 according to Examples and the sintered silicon nitride wafers according to Comparative Examples each was carried out. An AlN thin film was formed on the surface of the sintered silicon nitride wafers each by sputtering. A GaN single crystal was disposed on the AlN thin film. Thereby, samples in which the single crystal was disposed on the sintered silicon nitride wafers each were fabricated.

As an adhesion test with the single crystal, a TCT test was carried out on each sample. The TCT test involved taking -40°C × 30 min, room temperature × 10 min, 170°C × 30 min and room temperature × 10 min in order as one cycle and measuring the occurrence/non-occurrence of peeling of the single crystal and the AlN thin film after 1,000 cycles. The occurrence or non-occurrence of peeling of the single crystal and AlN thin film was measured. The occurrence/non-occurrence of peeling was checked by a SAT (ultrasonic flaw detection).

The case where the peeled area was 0% or larger and 3% or smaller was rated as good, and the case where the peeled area exceeded 3% was rated as defective.

**[Table 4]**

| | Adhesion Test with Single Crystal |
|---|---|
| Example 1 | Good |
| Example 2 | Good |
| Example 3 | Good |
| Example 4 | Good |
| Example 5 | Good |
| Comparative Example 1 | Defective |
| Comparative Example 2 | Defective |

As can be seen from the Tables, the sintered silicon nitride wafers 1 according to Examples were improved in the joining strength with the single crystal. Hence, it can be seen that control of the mean value of RSm was effective.

By contrast, in the case where the mean value of RSm was out of the range as in Comparative Example 1 and Comparative Example 2, the joining strength decreased. That is, when a thermal stress as in the TCT was applied, the performance was deteriorated.

While certain embodiments have been described, these embodiments have been presented by way of example only, and are not intended to limit the scope of the inventions. Indeed, the novel methods and systems described herein may be embodied in a variety of other forms; furthermore, various omissions, substitutions and changes in the form of the methods and systems described herein may be made without departing from the spirit of the inventions. The accompanying claims and their equivalents are intended to cover such forms or modifications as would fall within the scope and spirit of the inventions.

## Claims

1. A sintered silicon nitride wafer having a flat plate-shape,
wherein at least one surface of the wafer has a mean value, of mean lengths RSm of a plurality of roughness profile elements having a length of a plurality of line segments passing through the center of the surface being taken as a standard length, within the range of 100 µm or larger and 350 µm or smaller.

2. The sintered silicon nitride wafer according to claim 1, wherein the mean lengths RSm of the plurality of roughness profile elements are each within the range of 10 µm or larger and 800 µm or smaller.

3. The sintered silicon nitride wafer according to claim 1 or 2, wherein a mean value, of maximum profile valley depths Rv of the plurality of a roughness profile having the length of the plurality of line segments passing through the center of the surface being taken as a standard length, is within the range of 0.04 µm or larger and 0.4 µm or smaller.

4. The sintered silicon nitride wafer according to claim 1 or 2, wherein the maximum profile valley depths Rv of the plurality of a roughness profile having the length of the plurality of line segments passing through the center of the surface being taken as a standard length, are each within the range of 0.02 µm or larger and 2 µm or smaller.

5. The sintered silicon nitride wafer according to claim 3, wherein the maximum profile valley depths Rv of the plurality of the roughness profile having the length of the plurality of line segments passing through the center of the surface being taken as a standard length, are each within the range of 0.02 µm or larger and 2 µm or smaller.

6. The sintered silicon nitride wafer according to claim 1 or 2, wherein a mean value, of maximum heights Rt of the plurality of a roughness profile having the length of the plurality of line segments passing through the center of the surface being taken as a standard length, is within the range of 0.4 µm or larger and 2 µm or smaller.

7. The sintered silicon nitride wafer according to claim 1 or 2, wherein the maximum heights Rt of the plurality of a roughness profile having the length of the plurality of line segments passing through the center of the surface being taken as a standard length, are each within the range of 0.1 µm or larger and 4 µm or smaller.

8. The sintered silicon nitride wafer according to claim 5, wherein a mean value, of maximum heights Rt of the plurality of the roughness profile having the length of the plurality of line segments passing through the center of the surface being taken as a standard length, is within the range of 0.4 µm or larger and 1.4 µm or smaller.

9. The sintered silicon nitride wafer according to claim 8, wherein the maximum heights Rt of the plurality of the roughness profile having the length of the plurality of line segments passing through the center of the surface being taken as a standard length, are each within the range of 0.1 µm or larger and 4 µm or smaller.

10. The sintered silicon nitride wafer according to claim 1 or 2,
wherein the wafer is a wafer comprising a disc-shaped sintered silicon nitride; and
the plurality of line segments are a plurality of diameters.

11. The sintered silicon nitride wafer according to claim 4,
wherein the wafer is a wafer comprising a disc-shaped sintered silicon nitride; and
the plurality of line segments are a plurality of diameters.

12. The sintered silicon nitride wafer according to claim 9,
wherein the wafer is a wafer comprising a disc-shaped sintered silicon nitride; and
the plurality of line segments are a plurality of diameters.

13. A method for producing a single crystal body, comprising a step of disposing a single crystal on a sintered silicon nitride wafer according to claim 1 or 2.

14. A method for producing a single crystal body, comprising a step of disposing a single crystal on a sintered silicon nitride wafer according to claim 12.

15. The method for producing a single crystal body according to claim 13, comprising a step of forming a thin film on a sintered silicon nitride wafer, and a step of disposing the single crystal on the thin film formed.
